# EUROPEAN PATENT APPLICATION

(11) **EP 3 940 764 A1**
(43) Date of publication of application: **19.01.2022**
(21) Application number: 20769186.6
(22) Date of filing: 27.02.2020
(51) Int. Cl.: H01L 23/12, H01L 23/29, H01L 23/31, C09J 123/00, C09J 125/04, C09J 133/00, C09J 175/04, C09J 183/04, H01L 21/56, C09J 7/38

(54) **ELECTRONIC DEVICE MANUFACTURING METHOD**

(30) Priority: 14.03.2019 JP 2019046792
(71) Applicant: Mitsui Chemicals Tohcello, Inc., Tokyo 101-8485 (JP)
(72) Inventor: MIURA, Toru, Nagoya-shi, Aichi 457-0801 (JP); KURIHARA, Hiroyoshi, Nagoya-shi, Aichi 457-0801 (JP)
(74) Representative: Hoffmann Eitle
(86) International application number: PCT/JP2020/008007
(87) International publication number: WO 2020/184199

(57) **Abstract**

A method for manufacturing an electronic device includes at least a preparing step of preparing a structure (100) provided with an adhesive film (50) provided with a base material layer (10), an adhesive resin layer (A) provided on a first surface (10A) side of the base material layer (10) and used for temporarily fixing an electronic component (70), and an adhesive resin layer (B) provided on a second surface (10B) side of the base material layer (10) and in which an adhesive force is reduced by external stimuli, an electronic component (70) attached to the adhesive resin layer (A) of the adhesive film (50), and a support substrate (80) attached to the adhesive resin layer (B) of the adhesive film (50), a pre-baking step of heating the structure (100), and a sealing step of sealing the electronic component (70) with a sealing material (60).

## Description

### TECHNICAL FIELD

The present invention relates to a method for manufacturing an electronic device.

### BACKGROUND ART

As a technology which is able to reduce the size and weight of electronic devices (for example, semiconductor apparatuses), a fan-out type wafer level package (WLP) is being developed.

In an Embedded Wafer Level Ball Grid Array (eWLB), which is one of the methods for manufacturing a fan-out type WLP, it is possible to adopt a method in which a plurality of electronic components such as semiconductor chips are temporarily fixed in a separated state on an adhesive film attached to a support substrate, and the plurality of electronic components are sealed in a batch with a sealing material. Here, the adhesive film needs to be fixed to the electronic component and the support substrate in the sealing step or the like and needs to be removed from the sealed electronic component and the support substrate after the sealing.

Examples of a technique related to such a fan-out type WLP manufacturing method include the technique described in Patent Document 1 (Japanese Patent Laid-Open No. 2011-134811).

Patent Document 1 discloses a heat-resistant adhesive sheet for manufacturing a semiconductor apparatus, which is used by being attached when resin-sealing a substrateless semiconductor chip, in which the heat-resistant adhesive sheet has a base material layer and an adhesive layer, and the adhesive layer has an adhesive force to SUS304 after bonding of 0.5 N/20 mm or more, is cured by a stimulus received until the completion of a resin sealing step, and has a peel force with respect to a package of 2.0 N/20 mm or less.

### RELATED DOCUMENT

### PATENT DOCUMENT

[Patent Document 1] Japanese Patent Laid-Open No. 2011-134811

### SUMMARY OF THE INVENTION

### TECHNICAL PROBLEM

According to studies by the inventors of the present invention, it was clear that, when electronic components are arranged on an adhesive film and the electronic components are sealed with a sealing material, the position of the electronic components may shift (also referred to below as position shifting of the electronic components) .

The present invention is made in consideration of the above circumstances and provides a method for manufacturing an electronic device with which it is possible to suppress position shifting of electronic components in a sealing step.

### SOLUTION TO PROBLEM

The inventors of the present invention carried out intensive studies in order to achieve the above object. As a result, it was found that performing a pre-baking step before a sealing step makes it possible to suppress position shifting of electronic components in the sealing step, thereby completing the present invention.

According to the present invention, a method for manufacturing an electronic device illustrated below is provided.

[1] A method for manufacturing an electronic device, the method including at least a preparing step of preparing a structure provided with an adhesive film provided with a base material layer, an adhesive resin layer (A) provided on a first surface side of the base material layer and used for temporarily fixing an electronic component, and an adhesive resin layer (B) provided on a second surface side of the base material layer and in which an adhesive force is reduced by external stimuli, an electronic component attached to the adhesive resin layer (A) of the adhesive film, and a support substrate attached to the adhesive resin layer (B) of the adhesive film, a pre-baking step of heating the structure, and a sealing step of sealing the electronic component with a sealing material.
[2] The method for manufacturing an electronic device according to [1], in which a heating temperature in the pre-baking step is lower than 160°C.
[3] The method for manufacturing an electronic device according to [1] or [2], in which a heating temperature in the pre-baking step is 70°C or higher.
[4] The method for manufacturing an electronic device according to any one of [1] to [3], further including a first peeling step of peeling the support substrate from the structure by reducing an adhesive force of the adhesive resin layer (B) by applying an external stimulus, after the sealing step.
[5] The method for manufacturing an electronic device according to [4], further including a second peeling step of peeling the adhesive film from the electronic component, after the first peeling step.
[6] The method for manufacturing an electronic device according to any one of [1] to [5], in which the sealing material is an epoxy resin-based sealing material.
[7] The method for manufacturing an electronic device according to any one of [1] to [6], in which an adhesive resin forming the adhesive resin layer (A) includes one or two or more selected from a (meth) acrylic-based adhesive resin, a silicone-based adhesive resin, a urethane-based adhesive resin, an olefin-based adhesive resin, and a styrene-based adhesive resin.

### ADVANTAGEOUS EFFECTS OF INVENTION

According to the present invention, it is possible to provide a method for manufacturing an electronic device with which it is possible to suppress position shifting of electronic components in a sealing step.

### BRIEF DESCRIPTION OF THE DRAWINGS

Fig. 1 is a cross-sectional view schematically showing an example of a structure of an adhesive film of an embodiment according to the present invention.
Fig. 2 is a cross-sectional view schematically showing an example of a method for manufacturing an electronic device of an embodiment according to the present invention.
Fig. 3 is a cross-sectional view schematically showing an example of a method for manufacturing an electronic device of an embodiment according to the present invention.

### DESCRIPTION OF EMBODIMENTS

A description will be given below of embodiments of the present invention with reference to the drawings. In all the drawings, common reference numerals are given to the same constituent components and description thereof will not be repeated as appropriate. In addition, the figures are schematic views and do not match the actual dimensional ratios. In addition, unless otherwise specified, "A to B" in the numerical range represents A or more and B or less. In addition, in the present embodiment, "(meth)acrylic" means acrylic, methacrylic, or both acrylic and methacrylic.

### 1. Method for Manufacturing Electronic Device

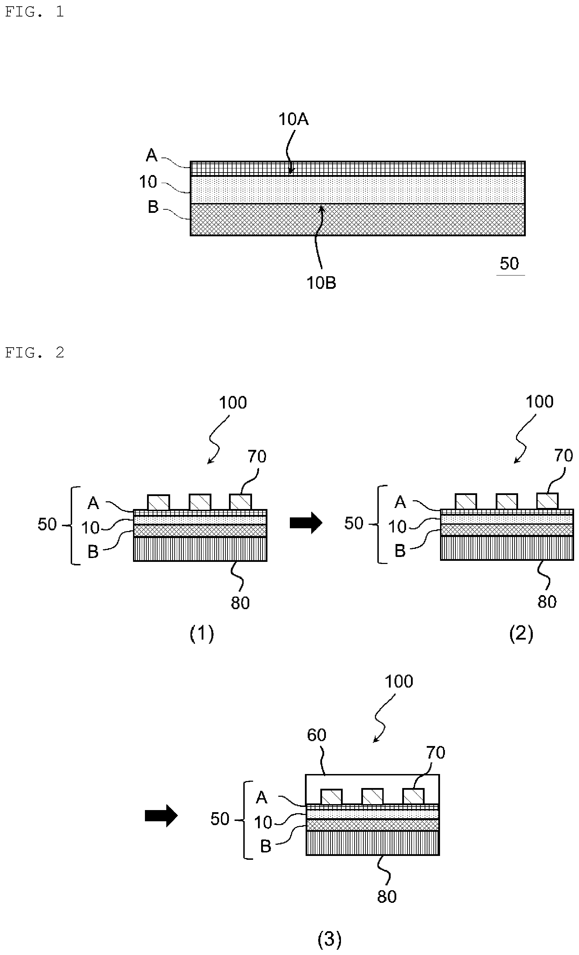

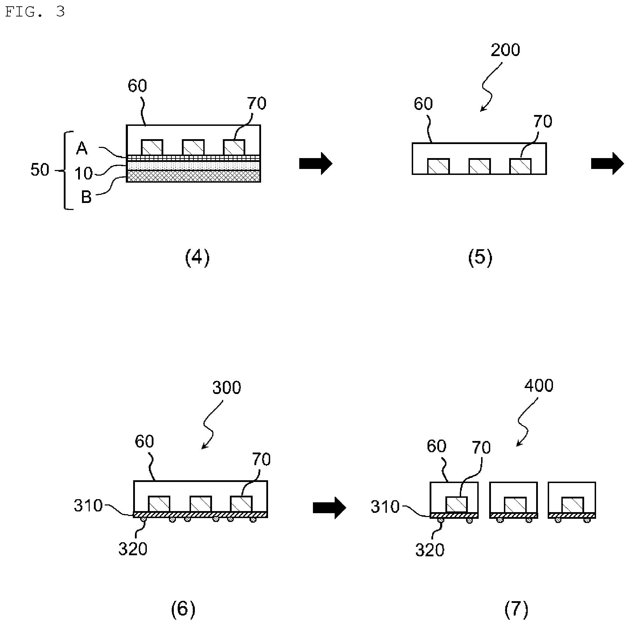

First, a description will be given of the method for manufacturing an electronic device according to the present embodiment. Fig. 1 is a cross-sectional view schematically showing an example of the structure of an adhesive film 50 of the embodiment according to the present invention. Fig. 2 and Fig. 3 are cross-sectional views schematically showing an example of a method for manufacturing an electronic device of an embodiment according to the present invention.

The method for manufacturing an electronic device according to the present embodiment is provided with at least the following three steps.
(1) A preparing step of preparing a structure 100 provided with the adhesive film 50 provided with a base material layer 10, the adhesive resin layer (A) provided on a first surface 10A side of the base material layer 10 and used for temporarily fixing an electronic component 70, and the adhesive resin layer (B) provided on a second surface 10B side of the base material layer 10 and in which an adhesive force is reduced by external stimuli, the electronic component 70 attached to the adhesive resin layer (A) of the adhesive film 50, and a support substrate 80 attached to the adhesive resin layer (B) of the adhesive film 50
(2) A pre-baking step of heating the structure 100
(3) A sealing step of sealing the electronic component 70 with a sealing material 60

As described above, according to studies by the inventors of the present invention, it was clear that, when electronic components are arranged on an adhesive film and the electronic components are sealed with a sealing material, the position of the electronic components may shift (also referred to below as position shifting of the electronic components).

The inventors of the present invention carried out intensive studies to resolve the above problems. As a result, it was found that, in the electronic component sealing step, the electronic components are not able to withstand the pressure caused by the flow of the sealing material and position shifting of the electronic components may occur. Furthermore, it was found that, due to outgas derived from moisture included in the adhesive film, in particular, outgas derived from moisture included in the adhesive resin layer on the side attached to the support substrate, position shifting of the electronic components may occur.

Based on the above findings, the inventors of the present invention carried out further studies. As a result, it was found for the first time that performing a pre-baking step of heating the structure 100 before the sealing step improves the adhesive force of the adhesive resin layer (A) with respect to the electronic components 70 and makes it possible to suppress position shifting of the electronic components in the sealing step.

That is, according to the method for manufacturing an electronic device according to the present embodiment, performing a pre-baking step of heating the structure 100 before the sealing step improves the adhesive force of the adhesive resin layer (A) with respect to the electronic component 70, thus, in the electronic component sealing step, it is possible to suppress position shifting of the electronic components 70 due to pressure caused by the flow of the sealing material 60 and outgas derived from moisture.

As described above, according to the method for manufacturing an electronic device according to the present embodiment, it is possible to suppress position shifting of the electronic component in the sealing step.

A description will be given below of each step of the method for manufacturing an electronic device according to the present embodiment.

### ((1) Preparing Step)

In the preparing step, the structure 100 provided with the adhesive film 50, the electronic component 70 attached to the adhesive resin layer (A) of the adhesive film 50, and the support substrate 80 attached to the adhesive resin layer (B) of the adhesive film 50 is prepared.

It is possible to manufacture the structure 100, for example, by the following procedure.

First, the adhesive film 50 is attached on the support substrate 80 such that the adhesive resin layer (B) is on the support substrate 80 side. A protective film called a separator may be attached on the adhesive resin layer (B) and it is possible to peel the protective film and attach the exposed surface of the adhesive resin layer (B) to the surface of the support substrate 80.

As the support substrate 80, for example, it is possible to use a quartz substrate, a glass substrate, a SUS substrate, or the like.

Next, it is possible to obtain the structure 100 by arranging the electronic component 70 on the adhesive resin layer (A) of the adhesive film 50 attached on the support substrate 80.

Examples of the electronic component 70 include a semiconductor chip such as an IC, an LSI, a discrete device, a light emitting diode, or a light receiving element, a semiconductor panel, a semiconductor package, and the like.

### ((2) Pre-baking Step)

In the pre-baking step, the structure 100 obtained in the preparing step is heated. In this manner, in the adhesive film 50, it is possible to improve the adhesive force of the adhesive resin layer (A) with respect to the electronic component 70. As a result, in the sealing step, when sealing the electronic component 70 with the sealing material 60, it is possible to suppress position shifting of the electronic component 70 due to pressure caused by the flow of the sealing material 60 and outgas derived from moisture.

The upper limit of the temperature when heating the structure 100 in the pre-baking step is not particularly limited as long as it is a temperature at which it is possible to improve the adhesive force of the adhesive resin layer (A) with respect to the electronic component 70, but less than 160°C is preferable, 155°C or lower is more preferable, and 150°C or lower is even more preferable. Due to this, it is possible to suppress the rapid generation of outgas derived from moisture included in the adhesive film and, as a result, it is possible to further suppress position shifting of the electronic components 70 due to outgas derived from moisture in the pre-baking step and the sealing step. In addition, in a case where the adhesive resin layer (B) is a heat-expanding type, when the temperature when heating the structure 100 is the same as or less than the upper limit value described above, heat expansion is suppressed, thus, the reduction in the adhesive force of the adhesive film 50 with respect to the support substrate 80 is suppressed and, as a result, it is possible to suppress the peeling of the adhesive film 50 from the support substrate 80 in the electronic component sealing step.

In the pre-baking step, the lower limit of the temperature when heating the structure 100 is not particularly limited as long as it is a temperature at which it is possible to improve the adhesive force of the adhesive resin layer (A) with respect to the electronic component 70, but 70°C or higher is preferable, 80°C or higher is more preferable, 90°C or higher is even more preferable, and 100°C or higher is yet more preferable. Due to this, it is possible to shorten the heating time in the pre-baking step and, as a result, to shorten the manufacturing time of the electronic device. When it is possible to shorten the manufacturing time of the electronic device, it is possible to improve the productivity of the electronic device.

The time for heating the structure 100 is not particularly limited as long as the heating time makes it possible to improve the adhesive force of the adhesive resin layer (A) with respect to the electronic component 70, but is, for example, in a range of 1 minute or more and 120 minutes or less, and preferably 5 minutes or more and 80 minutes or less.

The method for heating the structure 100 is not particularly limited, but, for example, it is possible to use a generally known heat treatment method such as an oven, a dryer, a heating roll, a drying oven, or the like.

It is possible to determine whether the adhesive force of the adhesive resin layer (A) with respect to the electronic component 70 is improved, for example, by a known method such as the shear strength between the electronic component 70 and the adhesive film 50.

### ((3) Sealing Step)

Next, the electronic component 70 is sealed with the sealing material 60.

The electronic component 70 is covered by the sealing material 60 and the sealing material 60 is cured at, for example, a temperature of 150°C or lower to seal the electronic component 70.

In addition, the form of the sealing material 60 is not particularly limited, but is, for example, granular, sheet-like, or liquid-like.

The sealing material 60 is not particularly limited, but, for example, it is possible to use an epoxy resin-based sealing material using an epoxy resin.

In particular, a liquid-like epoxy resin-based sealing material is preferable in terms of the affinity of the sealing material 60 to the adhesive film 50 being more favorable and being able to seal the electronic component 70 more evenly.

As such an epoxy resin-based sealing material, for example, it is possible to use the T693/R4000 series, the T693/R1000 series, the T693/R5000 series, and the like, manufactured by Nagase ChemteX Corporation.

Examples of sealing methods include transfer molding, injection molding, compression molding, casting molding, and the like. After sealing the electronic component 70 with the sealing material 60, the sealing material 60 is cured by heating at, for example, a temperature of 150°C or lower to obtain the structure 100 in which the electronic component 70 is sealed.

### ((4) First Peeling Step)

In the method for manufacturing an electronic device according to the present embodiment, as shown in Fig. 3, after the sealing step of (3), a first peeling step of peeling the support substrate 80 from the structure 100 by reducing the adhesive force of the adhesive resin layer (B) by applying an external stimulus thereto may be further provided.

It is possible to easily remove the support substrate 80 from the adhesive film 50 by, for example, sealing the electronic components 70 and then heating at a temperature over 150°C to reduce the adhesive force of the adhesive resin layer (B).

### ((5) Second Peeling Step)

In the method for manufacturing an electronic device according to the present embodiment, as shown in Fig. 3, after the first peeling step, a second peeling step of peeling the adhesive film 50 from the electronic component 70 to obtain an electronic device 200 may be further provided.

Examples of the method for peeling the adhesive film 50 from the electronic component 70 include a mechanical peeling method, a method of peeling after reducing the adhesive force on the surface of the adhesive film 50, or the like.

### (Other Steps)

In the method for manufacturing an electronic device according to the present embodiment, as shown in Fig. 3, a step (6) of forming a wiring layer 310 and bumps 320 on the exposed surface of the obtained electronic device 200 to obtain an electronic device 300 may be further provided.

The wiring layer 310 is provided with pads (not shown), which are external connection terminals formed on the outermost surface, and wiring (not shown), which electrically connects the exposed electronic component 70 and the pads. The wiring layer 310 is able to be formed by methods known in the related art and may be a multilayer structure.

Then, it is possible to form bumps 320 on the pads of the wiring layer 310 and obtain the electronic device 300. Examples of the bumps 320 include solder bumps, gold bumps, or the like. It is possible to form solder bumps, for example, by arranging a solder ball on the pad, which is an external connection terminal of the wiring layer 310, and heating and melting (reflowing) the solder. It is possible to form gold bumps by methods such as a ball bonding method, a plating method, and an Au ball transfer method.

In addition, in the method for manufacturing an electronic device according to the present embodiment, as shown in Fig. 3, a step (7) of dicing the electronic device 300 to obtain a plurality of electronic devices 400 may be further provided.

It is possible to perform the dicing of the electronic device 300 by a known method.

### 2. Adhesive Film

A description will be given below of the adhesive film 50 according to the present embodiment.

Fig. 1 is a cross-sectional view schematically showing an example of the structure of the adhesive film 50 of the embodiment according to the present invention.

As shown in Fig. 1, the adhesive film 50 according to the present embodiment is provided with the base material layer 10, the adhesive resin layer (A) provided on the first surface 10A side of the base material layer 10, and the adhesive resin layer (B) provided on the second surface 10B side of the base material layer 10 and in which an adhesive force is reduced by external stimuli.

From the viewpoint of the balance between mechanical properties and handleability, the total thickness of the adhesive film 50 according to the present embodiment is preferably 10 µm or more and 1000 µm or less, and more preferably 20 µm or more and 500 µm or less.

Next, a description will be given of each layer forming the adhesive film 50 according to the present embodiment.

### <Base Material Layer>

The base material layer 10 is a layer provided for the purpose of making the characteristics such as the handling, mechanical properties, heat resistance, and the like of the adhesive film 50 more favorable.

The base material layer 10 is not particularly limited and examples thereof include a resin film.

As the resin forming the resin film described above, it is possible to use a known thermoplastic resin. Examples thereof include one type or two or more types selected from polyolefins such as polyethylene, polypropylene, poly(4-methyl-1-pentene), and poly(1-butene); polyesters such as polyethylene terephthalate, polybutylene terephthalate, and polyethylene naphthalate; polyamides such as nylon-6, nylon-66, and polymetaxylene adipamide; polyacrylates; polymethacrylates; polyvinyl chlorides; polyvinylidene chlorides; polyimides; polyetherimides; ethylene/vinyl acetate copolymers; polyacrylonitriles; polycarbonates; polystyrenes; ionomers; polysulfones; polyethersulfones; polyphenylene ethers, and the like.

Among these, from the viewpoint of an excellent balance between the transparency, mechanical strength, price, and the like, one type or two or more types selected from polypropylene, polyethylene terephthalate, polyethylene naphthalate, polyamide, and polyimide are preferable, and at least one type selected from polyethylene terephthalate and polyethylene naphthalate is more preferable.

The base material layer 10 may be a single layer or a layer of two or more types.

In addition, the form of the resin film used to form the base material layer 10 may be a stretched film or a film stretched in the uniaxial or biaxial direction; however, from the viewpoint of improving the mechanical strength of the base material layer 10, a film stretched in the uniaxial or biaxial direction is preferable.

From the viewpoint of obtaining favorable film properties, the thickness of the base material layer 10 is preferably 1 µm or more and 500 µm or less, more preferably 5 µm or more and 300 µm or less, and even more preferably 10 µm or more and 250 µm or less.

The base material layer 10 may be subjected to a surface treatment in order to improve the adhesion with other layers. Specifically, a corona treatment, a plasma treatment, an undercoat treatment, a primer coat treatment, and the like may be performed.

### <Adhesive Resin Layer (A)>

The adhesive resin layer (A) is a layer provided on one surface side of the base material layer 10, for example, for contacting the surface of the electronic component to temporarily fix the electronic component when the electronic component is sealed with a sealing material in the electronic device manufacturing steps.

The adhesive resin layer (A) includes an adhesive resin (A1).

Examples of the adhesive resin (A1) include a (meth)acrylic-based adhesive resin (a), a silicone-based adhesive resin, a urethane-based adhesive resin, an olefin-based adhesive resin, a styrene-based adhesive resin, and the like.

Among the above, the (meth)acrylic-based adhesive resin (a) is preferable from the viewpoint of facilitating the adjustment of the adhesive force and the like.

As the adhesive resin layer (A), it is also possible to use a radiation cross-linking adhesive resin layer in which the adhesive force is reduced by radiation. The radiation cross-linking adhesive resin layer is cross-linked by the irradiation of radiation and the adhesive force is significantly reduced, thus, the adhesive film 50 is easily peeled from the electronic component. Examples of the radiation include ultraviolet rays, electron beams, infrared rays, and the like.

As the radiation cross-linking adhesive resin layer, an ultraviolet cross-linking adhesive resin layer is preferable.

Examples of the (meth)acrylic-based adhesive resin (a) used in the adhesive resin layer (A) include a copolymer including a (meth) acrylic acid alkyl ester monomer unit (a1) and a monomer unit (a2) having a functional group capable of reacting with a cross-linking agent.

In the present embodiment, the (meth)acrylic acid alkyl ester means an acrylic acid alkyl ester, a methacrylic acid alkyl ester, or a mixture thereof.

It is possible to obtain the (meth) acrylic-based adhesive resin (a) according to the present embodiment, for example, by copolymerizing a monomer mixture including a (meth) acrylic acid alkyl ester monomer (a1) and a monomer (a2) having a functional group capable of reacting with a cross-linking agent.

Examples of the monomer (a1) forming the (meth)acrylic acid alkyl ester monomer unit (a1) include a (meth) acrylic acid alkyl ester having an alkyl group having approximately 1 to 12 carbon atoms. A (meth)acrylic acid alkyl ester having an alkyl group having 1 to 8 carbon atoms is preferable. Specific examples thereof include methyl acrylate, methyl methacrylate, ethyl acrylate, ethyl methacrylate, butyl acrylate, butyl methacrylate, 2-ethylhexyl acrylate, 2-ethylhexyl methacrylate, and the like. These may be used alone or in a combination of two or more types.

In the (meth)acrylic-based adhesive resin (a) according to the present embodiment, when the total of all the monomer units in the (meth)acrylic-based adhesive resin (a) is 100% by mass, the content of the (meth) acrylic acid alkyl ester monomer unit (a1) is preferably 10% by mass or more and 98.9% by mass or less, more preferably 50% by mass or more and 97% by mass or less, and even more preferably 85% by mass or more and 95% by mass or less.

Examples of the monomer (a2) forming the monomer (a2) having a functional group capable of reacting with the cross-linking agent include acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, 2-hydroxyethyl acrylate, 2-hydroxyethyl methacrylate, acrylamide, methacrylamide, tert-butylaminoethyl acrylate, tert-butylaminoethyl methacrylate, and the like. Preferable are acrylic acid, methacrylic acid, 2-hydroxyethyl acrylate, 2-hydroxyethyl methacrylate, acrylamide, methacrylamide, and the like. These may be used alone or in a combination of two or more types.

In the (meth)acrylic-based adhesive resin (a) according to the present embodiment, when the total of all the monomer units in the (meth)acrylic-based adhesive resin (a) is 100% by mass, the content of the monomer unit (a2) is preferably 1% by mass or more and 40% by mass or less, more preferably 1% by mass or more and 20% by mass or less, and even more preferably 1% by mass or more and 10% by mass or less.

The (meth)acrylic-based adhesive resin (a) according to the present embodiment may, in addition to the monomer unit (a1) and the monomer unit (a2), further include a bifunctional monomer unit (a3) and a specific comonomer (referred to below as a polymerizable surfactant) unit having properties as a surfactant.

The polymerizable surfactant has a property of copolymerizing with the monomer (a1), the monomer (a2), and the monomer (a3), and also has an action as an emulsifier in the case of emulsion polymerization.

Examples of the monomer (a3) forming the bifunctional monomer unit (a3) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di(meth)acrylate, or, for example, monomers in which the main chain structure is a propylene glycol type with diacrylate or dimethacrylate at both ends (for example, manufactured by NOF Corp., trade name: PDP-200, PDP-400, ADP-200, and ADP-400), tetramethylene glycol type monomers (for example, manufactured by NOF Corp., trade name: ADT-250 and ADT-850), mixtures thereof (for example, manufactured by NOF Corp., trade name: ADET-1800 and ADPT-4000), and the like.

In the (meth)acrylic-based adhesive resin (a) according to the present embodiment, when the total of all the monomer units in the (meth)acrylic-based adhesive resin (a) is 100% by mass, the content of the monomer unit (a3) is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

Examples of the polymerizable surfactant include a surfactant in which a polymerizable 1-propenyl group is introduced into a benzene ring of polyoxyethylene nonylphenyl ether (manufactured by Daiichi Kogyo Seiyaku Co., Ltd.; trade name: Aqualon RN-10, RN-20, RN-30, RN-50, and the like), a surfactant in which a polymerizable 1-propenyl group is introduced into a benzene ring of ammonium salt of sulfuric acid ester of polyoxyethylene nonylphenyl ether (manufactured by Daiichi Kogyo Seiyaku Co., Ltd.; trade name: Aqualon HS-10, HS-20, HS-1025, and the like), and a sulfosuccinate diester-based surfactant having a polymerizable double bond in the molecule (manufactured by Kao Corp.; trade name: Latemul S-120A, S-180A, and the like), or the like.

In the (meth)acrylic-based adhesive resin (a) according to the present embodiment, when the total of all monomer units in the (meth)acrylic-based adhesive resin (a) is 100% by mass, the content of the polymerizable surfactant is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

The (meth)acrylic-based adhesive resin (a) according to the present embodiment may further contain a monomer unit formed of a monomer having a polymerizable double bond such as vinyl acetate, acrylonitrile, or styrene, as necessary.

Examples of the polymerization reaction mechanism of the (meth)acrylic-based adhesive resin (a) according to the present embodiment include radical polymerization, anionic polymerization, cationic polymerization, and the like. In consideration of the manufacturing cost of the (meth)acrylic-based adhesive resin (a), the influence of the functional group of the monomer, the influence of ions on the surface of the electronic component, and the like, it is preferable to carry out the polymerization by radical polymerization.

When polymerizing by a radical polymerization reaction, examples of radical polymerization initiators include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butylperoxyphthalate, t-butylperoxybenzoate, di-t-butylperoxyacetate, t-butylperoxyisobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide, and di-t-amyl peroxide; inorganic peroxides such as ammonium persulfate, potassium persulfate, and sodium persulfate; azo compounds such as 2,2'-azobisisobutyronitrile, 2,2'-azobis-2-methylbutyronitrile, and 4,4'-azobis-4-cyanovaleric acid.

In a case of polymerizing by an emulsion polymerization method, among these radical polymerization initiators, inorganic peroxides such as water-soluble ammonium persulfate, potassium persulfate, and sodium persulfate, and azo compounds having a carboxyl group in the molecule such as water-soluble 4,4'-azobis-4-cyanovaleric acid are preferable. Considering the influence of ions on the surface of the electronic components, ammonium persulfate and azo compounds having a carboxyl group in the molecule such as 4,4'-azobis-4-cyanovaleric acid are more preferable, and azo compounds having a carboxyl group in the molecule such as 4,4'-azobis-4-cyanovaleric acid are particularly preferable.

The adhesive resin layer (A) according to the present embodiment preferably further includes a cross-linking agent (A2) having two or more cross-linkable functional groups in one molecule, in addition to the adhesive resin (A1).

The cross-linking agent (A2) having two or more cross-linkable functional groups in one molecule is used to react with the functional group of the adhesive resin (A1) and adjust the adhesive force and aggregating force.

Examples of such a cross-linking agent (A2) include epoxy-based compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcinol diglycidyl ether; isocyanate-based compounds such as tetramethylene diisocyanate, hexamethylene diisocyanate, toluene diisocyanate 3 adduct of trimethylolpropane, polyisocyanate, diphenylmethane diisocyanate, and tolylene diisocyanate; aziridine-based compounds such as trimethylolpropane-tri-p-aziridinylpropionate, tetramethylolmethane-tri-p-aziridinylpropionate, N,N'-diphenylmethane-4,4'-bis(1-aziridinecarboxamide), N,N'-hexamethylene-1,6-bis(1-aziridinecarboxamide), N,N'-toluene-2,4-bis(1-aziridinecarboxamide), and trimethylolpropane-tri-β-(2-methylaziridine) propionate; tetrafunctional epoxy-based compounds such as N,N,N',N'-tetraglycidyl-m-xylenediamine and 1,3-bis(N,N'-diglycidylaminomethyl) cyclohexane; and melamine-based compounds such as hexamethoxymethylol melamine. These may be used alone or in a combination of two or more types.

Among the above, it is preferable to include one type or two or more types selected from an epoxy-based compound, an isocyanate-based compound, and an aziridine-based compound.

The content of the cross-linking agent (A2) is usually preferably in a range in which the number of functional groups in the cross-linking agent (A2) does not exceed the number of functional groups in the adhesive resin (A1). However, in a case where a functional group is newly generated in the cross-linking reaction, a case where the cross-linking reaction is slow, or the like, the content thereof may be greater as necessary.

From the viewpoint of improving the balance between the heat resistance and the adhesive force of the adhesive resin layer (A), the content of the cross-linking agent (A2) in the adhesive resin layer (A) is preferably 0.1 parts by mass or more and 15 parts by mass or less with respect to 100 parts by mass of the adhesive resin (A1).

The adhesive resin layer (A) may include additives such as plasticizers and tackifying resins as other components. In a case where the adhesive resin layer (A) is a radiation cross-linking adhesive resin layer, various additives for radiation cross-linking may be included. The total content of the adhesive resin (A1) and the cross-linking agent (A2) in the adhesive resin layer (A) is preferably 50% by mass or more when the entire adhesive resin layer (A) is 100% by mass, more preferably 70% by mass or more, even more preferably 90% by mass or more, and particularly preferably 95% by mass or more. Due to this, it is possible to further suppress adhesive residue on the electronic component side when the adhesive film is peeled from the electronic component.

The thickness of the adhesive resin layer (A) is not particularly limited, but is, for example, preferably 1 µm or more and 100 µm or less, and more preferably 3 µm or more and 50 µm or less.

It is possible to form the adhesive resin layer (A), for example, by coating an adhesive on the base material layer 10. The adhesive may be dissolved in a solvent and coated as a coating solution, coated as an aqueous emulsion, or directly coated as a liquid-like adhesive.

Among these, an adhesive coating solution dissolved in an organic solvent is preferable. The organic solvent is not particularly limited and may be appropriately selected from known organic solvents in consideration of solubility and drying time. Examples of organic solvents include ester-based organic solvents such as ethyl acetate and methyl acetate; ketone-based organic solvents such as acetone and MEK; aromatic-based organic solvents such as benzene, toluene, and ethylbenzene; linear or cyclic aliphatic-based organic solvents such as heptane, hexane, and cyclohexane; and alcohol-based organic solvents such as isopropanol and butanol. Ethyl acetate and toluene are preferable as the organic solvent. These solvents may be used alone as one type or used in a mixture of two or more types.

As a method for coating the adhesive coating solution, it is possible to adopt a coating method known in the related art, for example, a roll coater method, a reverse roll coater method, a gravure roll method, a bar coating method, a comma coater method, a die coater method, or the like. The drying conditions of the coated adhesive are not particularly limited, but in general, it is preferable to perform the drying in a temperature range of 80 to 200°C for 10 seconds to 10 minutes. More preferably, drying is performed at 80 to 170°C for 15 seconds to 5 minutes. In order to sufficiently promote the cross-linking reaction between the cross-linking agent and the adhesive, after the drying of the adhesive coating solution is completed, heating may be carried out at 40 to 80°C for approximately 5 to 300 hours.

In addition, the base material layer 10 and the adhesive resin layer (A) may be formed by coextrusion molding, or the film-like base material layer 10 and the film-like adhesive resin layer (A) may be formed by laminating (laminated).

### < Adhesive Resin Layer (B)>

The adhesive film 50 according to the present embodiment is provided with the adhesive resin layer (B) for which the adhesive force is reduced by an external stimulus, on the second surface 10B side on the opposite side to the first surface 10A of the base material layer 10.

Due to this, it is possible to easily peel the adhesive film 50 from the support substrate 80 by applying an external stimulus.

Here, examples of the adhesive resin layer (B), the adhesive force of which is reduced by an external stimulus, include a heat-peelable adhesive resin layer, the adhesive force of which is reduced by heating, a radiation-peelable adhesive resin layer, the adhesive force of which is reduced by radiation, and the like. Among the above, a heat-peelable adhesive resin layer, the adhesive force of which is reduced by heating, is preferable.

Examples of the heat-peelable adhesive resin layer include adhesive resin layers formed of a heat-expandable adhesive including a gas generating component, a heat-expandable adhesive including heat-expandable microspheres capable of expanding to reduce the adhesive force, a heat-expandable adhesive, the adhesive force of which is reduced by the cross-linking reaction of the adhesive components by heat, or the like.

In the present embodiment, the heat-expandable adhesive used in the adhesive resin layer (B) is an adhesive, the adhesive force of which is reduced or lost by heating at a temperature over 150°C, for example. For example, it is possible to select a material which does not peel at a temperature of 150°C or lower and which does peel at a temperature over 150°C and which preferably has an adhesive force such that the adhesive film 50 does not peel from the support substrate 80 during the electronic device manufacturing steps.

Here, it is possible to evaluate the reduction or loss of the adhesive force by heating at a temperature over 150°C, for example, by the peeling strength from a stainless-steel plate, measured after attaching the adhesive resin layer (B) side to the stainless-steel plate, performing a heating treatment at 140°C for one hour, and then heating at a temperature over 150°C for two minutes. The specific heating temperature when heating at a temperature over 150°C is set to a temperature higher than the temperature at which gas is generated or the temperature at which heat-expandable microspheres undergo heat expansion and is set as appropriate depending on the type of gas to be generated or the heat-expandable microspheres. In the present embodiment, loss of adhesive force means, for example, a case where the 180° peeling strength measured under conditions of 23°C and a tensile speed of 300 mm/min is less than 0.5 N/25 mm.

As the gas generating component used in the heat-expandable adhesive, for example, it is possible to use an azo compound, an azide compound, a Meldrum's acid derivative, or the like. In addition, it is also possible to use inorganic foaming agents such as ammonium carbonate, ammonium hydrogen carbonate, sodium hydrogen carbonate, ammonium nitrite, sodium borohydride, and various azides, or water; salts of fluoroalkane-based compounds such as trichloromonofluoromethane and dichloromonofluoromethane; azo-based compounds such as azobisisobutyronitrile, azodicarbonamide, and barium azodicarboxylate; hydrazine-based compounds such as paratoluenesulfonyl hydrazide, diphenylsulfone-3,3'-disulfonylhydrazide, 4,4'-oxybis(benzenesulfonyl hydrazide) and allylbis(sulfonylhydrazide); semicarbazide-based compounds such as p-toluylenesulfonyl semicarbazide, and 4,4'-oxybis(benzenesulfonyl semicarbazide); triazole-based compounds such as 5-morpholyl-1,2,3,4-thiatriazole; organic foaming agents such as N-nitroso compounds such as N,N'-dinitrosopentamethylenetetramine, and N,N'-dimethyl-N,N'-dinitrosoterephthalamide, and the like. The gas generating component may be added to the adhesive resin (B1) or may be directly bonded to the adhesive resin (B1).

As the heat-expandable microspheres used for the heat-expandable adhesive, for example, it is possible to use a microencapsulated foaming agent. Examples of such heat-expandable microspheres include microspheres in which a substance that is easily gasified and expanded by heating such as isobutane, propane, and pentane is sealed in a shell having elasticity, or the like. Examples of the material forming the shell include vinylidene chloride-acrylonitrile copolymer, polyvinyl alcohol, polyvinyl butyral, polymethyl methacrylate, polyacrylonitrile, polyvinylidene chloride, polysulfone, and the like. It is possible to manufacture heat-expandable microspheres by, for example, a coacervation method, an interfacial polymerization method, or the like.

It is possible to add heat-expandable microspheres to the adhesive resin.

It is possible to appropriately set the content of at least one type selected from the gas generating component and the heat-expandable microspheres according to the expansion ratio and the reduction in adhesive force of the heat-peelable adhesive resin layer (B) and the like without being particularly limited; however, for example, with respect to 100 parts by mass of the adhesive resin (B1) in the heat-peelable adhesive resin layer (B), the content is, for instance, 1 part by mass or more and 150 parts by mass or less, preferably 10 parts by mass or more and 130 parts by mass or less, and more preferably 12 parts by mass or more and 100 parts by mass or less.

It is preferable to implement the design such that the temperature at which gas is generated or the temperature at which the heat-expandable microspheres heat-expand is over 150°C.

Examples of the adhesive resin (B1) forming the heat-expandable adhesive include a (meth)acrylic-based resin (b), a urethane-based resin, a silicone-based resin, a polyolefin-based resin, a polyester-based resin, a polyamide-based resin, a fluorine-based resin, a styrene-diene block copolymer-based resin, and the like. Among these, the (meth)acrylic-based resin (b) is preferable.

Examples of the (meth) acrylic-based adhesive resin (b) used for the adhesive resin layer (B) include a copolymer including a (meth) acrylic acid alkyl ester monomer unit (b1) and a monomer unit (b2) having a functional group able to react with a cross-linking agent.

In the present embodiment, the (meth)acrylic acid alkyl ester means an acrylic acid alkyl ester, a methacrylic acid alkyl ester, or a mixture thereof.

It is possible to obtain the (meth) acrylic-based adhesive resin (b) according to the present embodiment, for example, by copolymerizing a monomer mixture including a (meth) acrylic acid alkyl ester monomer (b1) and a monomer (b2) having a functional group able to react with a cross-linking agent.

The monomer (b1) forming the (meth)acrylic acid alkyl ester monomer unit (b1) includes (meth)acrylic acid alkyl esters having an alkyl group of approximately 1 to 12 carbon atoms. A (meth) acrylic acid alkyl ester having an alkyl group having 1 to 8 carbon atoms is preferable. Specific examples thereof include methyl acrylate, methyl methacrylate, ethyl acrylate, ethyl methacrylate, butyl acrylate, butyl methacrylate, 2-ethylhexyl acrylate, 2-ethylhexyl methacrylate, and the like. These may be used alone or in a combination of two or more types.

In the (meth)acrylic-based adhesive resin (b) according to the present embodiment, the content of the (meth) acrylic acid alkyl ester monomer unit (b1) is preferably 10% by mass or more and 98. 9% by mass or less when the total of all monomer units in the (meth) acrylic-based adhesive resin (b) is 100% by mass, more preferably 50% by mass or more and 97% by mass or less, and even more preferably 85% by mass or more and 95% by mass or less.

Examples of the monomers (b2) forming the monomer (b2) having a functional group able to react with the cross-linking agent include acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, 2-hydroxyethyl acrylate, 2-hydroxyethyl methacrylate, acrylamide, methacrylamide, tert-butylaminoethyl acrylate, tert-butylaminoethyl methacrylate, and the like. Acrylic acid, methacrylic acid, 2-hydroxyethyl acrylate, 2-hydroxyethyl methacrylate, acrylamide, methacrylamide, and the like are preferable. These may be used alone or in a combination of two or more types.

In the (meth)acrylic-based adhesive resin (b) according to the present embodiment, the content of the monomer unit (b2) is preferably 1% by mass or more and 40% by mass or less when the total of all monomer units in the (meth) acrylic-based adhesive resin (b) is 100% by mass, more preferably 1% by mass or more and 20% by mass or less, and even more preferably 1% by mass or more and 10% by mass or less.

The (meth)acrylic-based adhesive resin (b) according to the present embodiment may further include, in addition to the monomer unit (b1) and the monomer unit (b2), a bifunctional monomer unit (b3) and a specific comonomer (referred to below as a polymerizable surfactant) unit having properties as a surfactant.

The polymerizable surfactant has a property of copolymerizing with monomer (b1), monomer (b2), and monomer (b3) and also acts as an emulsifier in a case where emulsion polymerization is performed.

Examples of the monomers (b3) forming the bifunctional monomer units (b3) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di(meth)acrylate, or examples in which the structure of the main chain is a propylene glycol-type with diacrylate or dimethacrylate at both ends (for example, manufactured by NOF Corp., trade name: PDP-200, PDP-400, ADP-200, and ADP-400), tetramethylene glycol type (for example, manufactured by NOF Corp., trade name: ADT-250 and ADT-850), and mixed types thereof (for example, manufactured by NOF Corp., trade name: ADT-1800 and ADPT-4000).

In the (meth)acrylic-based adhesive resin (b) according to the present embodiment, the content of the monomer unit (b3) is preferably 0.1% by mass or more and 30% by mass or less when the total of all monomer units in the (meth)acrylic-based adhesive resin (b) is 100% by mass, more preferably 0.1% by mass or more and 15% by mass or less, even more preferably 0.1% by mass or more and 20% by mass or less, and particularly preferably 0.1% by mass or more and 5% by mass or less.

Examples of the polymerizable surfactant include a surfactant in which a polymerizable 1-propenyl group is introduced into a benzene ring of polyoxyethylene nonylphenyl ether (manufactured by Daiichi Kogyo Seiyaku Co., Ltd.; trade name: Aqualon RN-10, RN-20, RN-30, RN-50, and the like), a surfactant in which a polymerizable 1-propenyl group is introduced into a benzene ring of ammonium salt of sulfuric acid ester of polyoxyethylene nonylphenyl ether (manufactured by Daiichi Kogyo Seiyaku Co., Ltd.; trade name: Aqualon HS-10, HS-20, HS-1025, and the like), and a sulfosuccinate diester-based surfactant having a polymerizable double bond in the molecule (manufactured by Kao Corp.; trade name: Latemul S-120A, S-180A, and the like), or the like.

In the (meth)acrylic-based adhesive resin (b) according to the present embodiment, the content of the polymerizable surfactant is preferably 0.1% by mass or more and 30% by mass or less when the total of all monomer units in the (meth) acrylic-based adhesive resin (b) is 100% by mass, more preferably 0.1% by mass or more and 15% by mass or less, even more preferably 0.1% by mass or more and 20% by mass or less, and particularly preferably 0.1% by mass or more and 5% by mass or less.

The (meth)acrylic-based adhesive resin (b) according to the present embodiment may further contain a monomer unit formed of a monomer having a polymerizable double bond such as vinyl acetate, acrylonitrile, or styrene, as necessary.

Examples of the polymerization reaction mechanism of the (meth)acrylic-based adhesive resin (b) according to the present embodiment includes radical polymerization, anionic polymerization, cationic polymerization, and the like. In consideration of the manufacturing cost of the (meth)acrylic-based adhesive resin (b), the influence of functional groups of the monomer, the influence of ions on the surface of the electronic component, and the like, polymerization by radical polymerization is preferable.

When polymerizing by a radical polymerization reaction, examples of radical polymerization initiators include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butylperoxyphthalate, t-butylperoxybenzoate, di-t-butylperoxyacetate, t-butylperoxyisobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide, and di-t-amyl peroxide; inorganic peroxides such as ammonium persulfate, potassium persulfate, and sodium persulfate; azo compounds such as 2,2'-azobisisobutyronitrile, 2,2'-azobis-2-methylbutyronitrile, and 4,4'-azobis-4-cyanovaleric acid.

In a case of polymerizing by an emulsion polymerization method, among these radical polymerization initiators, inorganic peroxides such as water-soluble ammonium persulfate, potassium persulfate, and sodium persulfate, and azo compounds having a carboxyl group in the molecule such as water-soluble 4,4'-azobis-4-cyanovaleric acid are preferable. Considering the influence of ions on the surface of the electronic components, ammonium persulfate and azo compounds having a carboxyl group in the molecule such as 4,4'-azobis-4-cyanovaleric acid are more preferable, and azo compounds having a carboxyl group in the molecule such as 4,4'-azobis-4-cyanovaleric acid are particularly preferable.

The adhesive resin layer (B) according to the present embodiment further includes, in addition to the adhesive resin (B1), a cross-linking agent (B2) having two or more cross-linkable functional groups in one molecule.

The cross-linking agent (B2) having two or more cross-linkable functional groups in one molecule is used to react with the functional groups having the adhesive resin (B1) and adjust the adhesive force and aggregating force.

Examples of such cross-linking agents (B2) include epoxy compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcinol diglycidyl ether; isocyanate compounds such as tetramethylene diisocyanate, hexamethylene diisocyanate, toluene diisocyanate 3 adduct of trimethylolpropane, polyisocyanate, diphenylmethane diisocyanate, and tolylene diisocyanate; aziridine compounds such as trimethylolpropane tri-β-aziridinyl propionate, tetramethylolmethane-tri-β-aziridinyl propionate, N,N'-diphenylmethane-4,4'-bis(1-aziridinecarboxyamide) , N,N'-hexamethylene-1,6-bis(1-aziridinecarboxyamide), N,N'-toluene 2,4-bis(1-aziridinecarboxyamide), and trimethylolpropane-tri-β-(2-methylaziridine) propionate; tetrafunctional epoxy compounds such as N,N,N',N'-tetraglycidyl-m-xylenediamine, and 1,3-bis(N,N'-diglycidylaminomethyl) cyclohexane; melamine-based compounds such as hexamethoxymethylol melamine, and the like. These may be used alone or in a combination of two or more types.

Among the above, it is preferable to include one type or two or more types selected from epoxy-based compounds, isocyanate-based compounds, and aziridine-based compounds.

Usually, the content of the cross-linking agent (B2) is preferably in a range where the number of functional groups in the cross-linking agent (B2) does not exceed the number of functional groups in the adhesive resin (B1). However, in a case where new functional groups are created in the cross-linking reaction, in a case where the cross-linking reaction is slow, and the like, the content thereof may be greater as necessary.

The content of the cross-linking agent (B2) in the adhesive resin layer (B) is preferably 0.1 parts by mass or more and 10 parts by mass or less with respect to 100 parts by mass of the adhesive resin (B1), and more preferably 0.5 parts by mass or more and 5 parts by mass or less.

The adhesive resin layer (B) according to the present embodiment preferably includes a tackifying resin in addition to the adhesive resin (B1) from the viewpoint of improving the adhesion to the support substrate. Containing a tackifying resin in the adhesive resin layer (B) is preferable for facilitating adjustment of the adhesion to the support substrate near room temperature. A tackifying resin in which the softening point is 100°C or higher is preferable. Specific examples of tackifying resins include rosin-based resins such as rosin-based derivatives treated by esterification or the like; terpene-based resins such as α-pinene-based, β-pinene-based, dipentene-based, and terpene phenol-based resins; natural rosins such as gum-based, wood-based, and tall oil-based rosins; hydrogenated, disproportionated, polymerized, maleated, petroleum resins in these natural rosins; coumaron-indene resins, and the like.

Among these, examples having a softening point in the range of 100 to 160°C are more preferable and examples having a softening point in the range of 120 to 150°C are particularly preferable. Using a tackifying resin with a softening point within the above range not only minimizes contamination and adhesive residue on the support substrate, but also further improves adhesion to the support substrate in a working environment. Furthermore, when a polymerized rosin ester-based tackifying resin is used as the tackifying resin, not only are contamination and adhesive residue on the support substrate minimized, but also adhesion to the support substrate in an environment of 80 to 130°C is improved, and in a case of a heat-expandable adhesive including heat-expandable microspheres, it is possible to more easily carry out the peeling from the support substrate after expansion of the heat-expandable microspheres.

The blending ratio of the tackifying resin may be appropriately selected such that it is possible to adjust the elastic modulus of the adhesive resin layer (B) within a predetermined numerical range as desired, without being particularly limited. However, in terms of the elastic modulus of the adhesive resin layer (B) and the initial peeling force, the blending ratio is preferably 1 to 100 parts by mass with respect to 100 parts by mass of the adhesive resin (B1). When the blending ratio of the tackifying resin is the lower limit value described above or more with respect to 100 parts by mass of the adhesive resin (B1), there is a tendency for the adhesion to the support substrate during work to be favorable. On the other hand, when the blending ratio is the upper limit value described above or less, there is a tendency for the attachment property to the support substrate at room temperature to be favorable. In terms of the adhesion with the support substrate and the attachment property at room temperature, the blending ratio of the tackifying resin is more preferably 2 to 50 parts by mass with respect to 100 parts by mass of the adhesive resin (B1). In addition, the acid value of the tackifying resin is preferably 30 or less. When the acid value of the tackifying resin is the upper limit value described above or less, there is a tendency for it to be difficult for adhesive residue to be left on the support substrate during peeling.

The adhesive resin layer (B) may include additives such as plasticizers as other components. When the entire adhesive resin layer (B) is 100% by mass, the total content of the adhesive resin (B1), the cross-linking agent (B2), and the tackifying resin in the adhesive resin layer (B) is preferably 50% by mass or more, more preferably 70% by mass or more, even more preferably 90% by mass or more, and particularly preferably 95% by mass or more. Furthermore, in a case where the adhesive resin layer (B) is formed of a heat-expandable adhesive, when the entire adhesive resin layer (B) is 100% by mass, the total content of the adhesive resin (B1), the cross-linking agent (B2), the tackifying resin, the gas generating component, and the heat-expandable microspheres in the adhesive resin layer (B) is preferably 50% by mass or more, more preferably 70% by mass or more, even more preferably 90% by mass or more, and particularly preferably 95% by mass or more.

The thickness of the adhesive resin layer (B) is not particularly limited, but, for example, is preferably 5 µm or more and 300 µm or less, and more preferably 20 µm or more and 150 µm or less.

It is possible to form the adhesive resin layer (B), for example, by a method of coating an adhesive coating solution on the base material layer 10, a method of transferring the adhesive resin layer (B) formed on a separator onto the base material layer 10, or the like.

As a method for coating the adhesive coating solution, it is possible to adopt a coating method known in the related art, for example, a roll coater method, a reverse roll coater method, a gravure roll method, a bar coating method, a comma coater method, a die coater method, or the like. The drying conditions of the coated adhesive are not particularly limited, but in general, it is preferable to perform the drying in a temperature range of 80 to 200°C for 10 seconds to 10 minutes. More preferably, drying is performed at 80 to 170°C for 15 seconds to 5 minutes. In order to sufficiently promote the cross-linking reaction between the cross-linking agent and the adhesive, after the drying of the adhesive coating solution is completed, heating may be carried out at 40 to 80°C for approximately 5 to 300 hours.

In addition, the base material layer 10 and the adhesive resin layer (B) may be formed by co-extrusion molding or the film-like base material layer 10 and the film-like adhesive resin layer (B) may be formed by laminating (laminated).

### <Other Layers>

In the adhesive film 50 according to the present embodiment, an unevenness-absorbing layer, a shock-absorbing layer, an easy-adhesive layer, or the like may be further provided between the base material layer 10 and the adhesive resin layer (A) or between the base material layer 10 and the adhesive resin layer (B) in a range in which the effect of the present embodiment is not impaired.

The unevenness-absorbing layer is preferably formed by natural rubber, synthetic rubber, or a synthetic resin having rubber elasticity, having a Shore D-type hardness of, for example, 50 or less, preferably 40 or less, according to ASTM D-2240 D-type Shore. The thickness of the unevenness-absorbing layer is, for example, 500 µm or less, preferably 5 µm to 300 µm, and more preferably 10 µm to 150 µm.

Examples of synthetic rubbers or synthetic resins include synthetic rubbers such as nitrile-based, diene-based, and acrylic-based rubbers, thermoplastic elastomers such as polyolefin-based and polyester-based elastomers, and synthetic resins having rubber elasticity such as ethylene vinyl acetate copolymers, polyurethane, polybutadiene, and soft polyvinyl chloride. It is possible to use even polymers that are essentially rigid, such as polyvinyl chloride, in the present embodiment when combined with blending agent such as a plasticizer or a softener to impart rubber elasticity. In addition, it is also possible to preferably use the adhesive resins and the like exemplified in the adhesive resin layer (A) and adhesive resin layer (B) to form an unevenness-absorbing layer.

A description was given above of the embodiments of the present invention, but these are examples of the present invention and it is also possible to adopt various configurations other than the above.

Here, the present invention is not limited to the embodiments described above and modifications, improvements, and the like in a range in which it is possible to achieve the object of the present invention are included in the present invention.

### [Examples]

A detailed description will be given of the present invention using Examples, but the present invention is not limited thereto.

The details of the materials used to manufacture the adhesive film are as follows.

### <Adhesive Resin Solution SA1>

In pure water subjected to deionization, 0.5 parts by mass of 4, 4'-azobis-4-cyanovaleric acid (manufactured by Otsuka Chemical Co., Ltd., trade name: ACVA) as a polymerization initiator, 74.3 parts by mass of n-butyl acrylate and 13.7 parts by mass of methyl methacrylate as monomer as monomer (a1), 9 parts by mass of 2-hydroxyethyl methacrylate as monomer (a2), and 3 parts by mass of a polymerizable surfactant in which a polymerizable 1-propenyl group was introduced into a benzene ring of ammonium salt of a sulfate ester of polyoxyethylene nonylphenyl ether (manufactured by DKS Co., Ltd.; trade name: Aqualon HS-1025) were each added and emulsion polymerization was carried out for 8 hours at 70 to 72°C while stirring to obtain an acrylic-based resin emulsion. The result was neutralized (pH=7.0) with ammonia water to obtain an adhesive resin solution SA1 having a solid content concentration of 42.5%.

### <Adhesive Resin Solution SA2>

In pure water subjected to deionization, 0.5 parts by mass of ammonium persulfate as a polymerization initiator, 63 parts by mass of acrylic acid-2-ethylhexyl, 21 parts by mass of acrylic acid-n-butyl, and 9 parts by mass of methyl methacrylate as monomer (a1), 3 parts by mass of 2-hydroxyethyl methacrylate as monomer (a2), 1 part by mass of polytetramethylene glycol diacrylate (manufactured by NOF Corp., trade name: ADT-250) as monomer (a3), and 2 parts by mass of a polymerizable surfactant in which a polymerizable 1-propenyl group was introduced into a benzene ring of ammonium salt of a sulfate ester of polyoxyethylene nonylphenyl ether (manufactured by DKS Co., Ltd.; trade name: Aqualon HS-1025) were each added and emulsion polymerization was carried out for 8 hours at 70 to 72°C while stirring to obtain an acrylic-based resin emulsion. The result was neutralized (pH=7.0) with ammonia water to obtain an adhesive resin solution SA2 having a solid content concentration of 56.5%.

### <Adhesive Coating Solution A1>

57.4 parts by mass of the adhesive resin solution SA1, 42.6 parts by mass of the adhesive resin solution SA2, 0.4 parts by mass of dimethyl ethanolamine, and 3.4 parts by mass of epoxy-based compound (Ex-1610 manufactured by Nagase ChemteX Corporation), as a cross-linking agent, were each mixed to obtain an adhesive coating solution A1.

### <Adhesive Resin Solution SB1>

In a mixed solvent including ethyl acetate and toluene, 0.536 parts by mass of t-butyl peroxy-2-ethyl hexanoate (manufactured by NOF Corp., trade name: Perbutyl O (registered trademark)) as a polymerization initiator, 34.9 parts by weight of 2-ethylhexyl acrylate, 41 parts by mass of n-butyl acrylate, and 14.7 parts by mass of ethyl acrylate as monomer (b1), and 9.4 parts by mass of 2-hydroxyethyl methacrylate as monomer (b2) were each added and solution polymerization was carried out for 11 hours at 83 to 87°C while stirring to obtain an acrylic-based resin solution with a solid content concentration of 45% by mass. This was used as the adhesive resin solution SB1.

### <Adhesive Coating Solution B1>

100 parts by mass of the adhesive resin solution SB1 and 0.9 parts by mass (2 parts by mass with respect to 100 parts by mass of the adhesive resin) of an isocyanate-based cross-linking agent (manufactured by Mitsui Chemicals, Inc., trade name: Orestar P49-75S) were each mixed and the solid content concentration was adjusted to 40% with ethyl acetate to obtain the adhesive coating solution B1.

### <Adhesive Coating Solution B2>

100 parts by mass of the adhesive resin solution SB1, 2.25 parts by weight (5 parts by mass with respect to 100 parts by mass of the adhesive resin) of a polymerized rosin ester-based tackifying agent (manufactured by Arakawa Chemical Industries, Ltd., trade name: Pensel D-125), 1.2 parts by mass (2 parts by mass with respect to 100 parts by mass of the adhesive resin) of an isocyanate-based cross-linking agent (manufactured by Mitsui Chemicals, Inc., trade name: Orestar P49-75S), and 6. 75 parts by mass (15 parts by mass with respect to 100 parts by mass of the adhesive resin) of heat-expandable microspheres (manufactured by Sekisui Chemical Co., Ltd., trade name: Advancell EM-503) were each mixed and the solid content concentration was adjusted to 30% with ethyl acetate to prepare the adhesive coating solution B2.

### [Example 1]

On a polyethylene terephthalate (PET) film (thickness: 38 µm), which was the base material layer, the adhesive resin layer (A) with a thickness of 10 µm formed by drying the adhesive coating solution A1 was provided. Next, on the surface of the PET film on the opposite side of the adhesive resin layer (A), a 20 µm thick unevenness-absorbing layer formed by drying the adhesive coating solution B1 was provided, and a 30 µm thick heat-peelable type adhesive resin layer (B) formed by drying the adhesive coating solution B2 was provided thereon to obtain an adhesive film.

The adhesive resin layer (B) side of the obtained adhesive film was adhered on a 320 mm square SUS substrate and 5 mm square semiconductor chips as electronic components were placed and adhered on the adhesive resin layer (A) of the adhesive film so as to form a grid shape with 2 mm intervals to obtain a structure.

Next, the structure was pre-baked by performing a heat treatment for 30 minutes at 100°C with respect to the obtained structure.

For the structure after pre-baking, position shifting of the semiconductor chips was observed visually and evaluated according to the following criteria.
A: No position shifting in any of the electronic components
B: At least one electronic component moved and shifted from the original position

Furthermore, for the structure after pre-baking, the presence or absence of heat expansion of the adhesive resin layer (B) was observed visually and evaluated according to the following criteria. The obtained results are shown in Table 1.
A: No change in the external appearance of the adhesive resin layer (B)
B: Adhesive resin layer (B) expanded

Then, using a compression molding machine, a plurality of semiconductor chips on the adhesive resin layer (A) were sealed by compression molding at 135°C with a granular epoxy resin-based sealing material (manufactured by Sumitomo Bakelite Co., Ltd., trade name: G730) to obtain an electronic device.

Next, position shifting of the semiconductor chips was observed visually and evaluated according to the following criteria. The obtained results are shown in Table 1.
A: No position shifting in any of the electronic components
B: At least one electronic component moved and shifted from the original position

### [Examples 2 to 6]

The structures and electronic devices were manufactured with the same method as in Example 1 except that the conditions of the heat treatment in the pre-baking step were changed to the conditions shown in Table 1 and each evaluation was performed in the same manner as Example 1.

The obtained results are shown in Table 1.

### [Comparative Example 1]

The structure and electronic device were manufactured with the same method as in Example 1 except that the pre-baking step was not performed and each evaluation was performed in the same manner as Example 1.

The obtained results are shown in Table 1.

**[Table 1]**

| | Pre-baking conditions | | Electronic component position shifting evaluation | | Presence or absence of heat expansion in adhesive resin layer (B) |
|---|---|---|---|---|---|
| | Heating temperature [°C] | Heating time [min] | After pre-baking | After sealing step | |
| Example 1 | 100 | 30 | A | A | A |
| Example 2 | 130 | 30 | A | A | A |
| Example 3 | 145 | 30 | A | A | A |
| Example 4 | 130 | 10 | A | A | A |
| Example 5 | 130 | 60 | A | A | A |
| Example 6 | 150 | 30 | A | A | A |
| Comparative Example 1 | - | - | - | B | - |

- A:: Adhesive resin layer
- B:: Adhesive resin layer
- 10:: Base material layer
- 10A:: First surface
- 10B:: Second surface
- 50:: Adhesive film
- 60:: Sealing material
- 70:: Electronic component
- 80:: Support substrate
- 100:: Structure
- 200:: Electronic device
- 300:: Electronic device
- 310:: Wiring layer
- 320:: Bump
- 400:: Electronic device

This application claims priority based on Japanese Application 2019-046792 filed on March 14, 2019, the entire disclosure of which is incorporated herein.

## Claims

1. A method for manufacturing an electronic device, the method comprising at least:
a preparing step of preparing a structure provided with an adhesive film provided with a base material layer, an adhesive resin layer (A) provided on a first surface side of the base material layer and used for temporarily fixing an electronic component, and an adhesive resin layer (B) provided on a second surface side of the base material layer and in which an adhesive force is reduced by external stimuli,
an electronic component attached to the adhesive resin layer (A) of the adhesive film, and
a support substrate attached to the adhesive resin layer (B) of the adhesive film;
a pre-baking step of heating the structure; and
a sealing step of sealing the electronic component with a sealing material.

2. The method for manufacturing an electronic device according to claim 1,
wherein a heating temperature in the pre-baking step is lower than 160°C.

3. The method for manufacturing an electronic device according to claim 1 or 2,
wherein a heating temperature in the pre-baking step is 70°C or higher.

4. The method for manufacturing an electronic device according to any one of claims 1 to 3, further comprising:
a first peeling step of peeling the support substrate from the structure by reducing an adhesive force of the adhesive resin layer (B) by applying an external stimulus, after the sealing step.

5. The method for manufacturing an electronic device according to claim 4, further comprising:
a second peeling step of peeling the adhesive film from the electronic component, after the first peeling step.

6. The method for manufacturing an electronic device according to any one of claims 1 to 5,
wherein the sealing material is an epoxy resin-based sealing material.

7. The method for manufacturing an electronic device according to any one of claims 1 to 6,
wherein an adhesive resin forming the adhesive resin layer (A) includes one or two or more selected from a (meth)acrylic-based adhesive resin, a silicone-based adhesive resin, a urethane-based adhesive resin, an olefin-based adhesive resin, and a styrene-based adhesive resin.
